(19) Europäisches Patentamt
European Patent Office
Office européen des brevets

(11) **EP 0 559 944 B1**

(12) **EUROPÄISCHE PATENTSCHRIFT**

(45) Veröffentlichungstag und Bekanntmachung des Hinweises auf die Patenterteilung:
**28.02.1996   Patentblatt 1996/09**

(51) Int Cl.$^6$: **H03M 3/02**

(21) Anmeldenummer: **92104317.0**

(22) Anmeldetag: **12.03.1992**

(54) **Sigma-Delta-Modulator**

Sigma-Delta-modulator

Modulateur du type sigma-delta

(84) Benannte Vertragsstaaten:
**DE FR GB IT**

(43) Veröffentlichungstag der Anmeldung:
**15.09.1993   Patentblatt 1993/37**

(73) Patentinhaber:
**SIEMENS AKTIENGESELLSCHAFT**
**D-80333 München (DE)**

(72) Erfinder:
• **Koch, Rudolf, Dr. Ing.**
  **W-8025 Unterhaching (DE)**
• **Mauthe, Manfred, Dipl.-Ing.**
  **W-8011 Aying, Grosshelfendorf (DE)**

(56) Entgegenhaltungen:
**EP-A- 0 328 318**          **EP-A- 0 450 947**

• **IEEE TRANSACTIONS ON CIRCUITS AND SYSTEMS Bd. 38, Nr. 5, Mai 1991, NEW YORK US Seiten 489 - 497 , XP240137 L. A. WILLIAMS ET AL. 'Third-Order Cascaded Sigma- Delta Modulators'**

**Beschreibung**

Die Erfindung betrifft einen Sigma-Delta-Modulator.

Analog-Digital-Wandler mit Sigma-Delta-Modulatoren zeichnen sich gegenüber anderen Wandlerarten durch einen geringeren Aufwand an analoger Schaltungstechnik auf. Im einfachsten Fall, nämlich für einen Sigma-Delta-Modulator erster Ordnung, werden lediglich ein Integrator mit Differenzeingang, ein Komparator zur Ein-Bit-Quantisierung sowie eine Referenzspannungsquelle zur Digital-Analog-Wandlung benötigt. Dabei wird mit hoher Überabtastung statt mit hoher Auflösung gearbeitet und in einem nachfolgenden digitalen, also unkritischen Rauschfilter aus dem hochfrequenten Signal geringer Auflösung ein niederfrequentes Signal hoher Auflösung gewonnen. Vorteil dabei ist nun, daß die erzielbare Auflösung durch den Überabtastfaktor und die Rauschfilterung bestimmt wird, während Bauteiletoleranzen dagegen die Auflösung im wesentlichen nicht beeinflussen.

Bei Erhöhung der Modulatorordnung steigt die Auflösung um 6 dB pro Verdopplung des Uberabtastfaktors. Ein Modulator erster Ordnung hat dabei eine Auflösung von etwa 9 dB pro Verdoppelung des Überabtastfaktors. Bei einem Modulator zweiter Ordnung beträgt demnach dieser Wert etwa 15 dB und bei dritter Ordnung etwa 21 dB.

Weit verbreitet, insbesondere im Audiobereich, sind Sigma-Delta-Modulatoren zweiter Ordnung. Bei einem Sprachband mit einer Bandbreite von 8 KHz und einer Abtastfrequenz von 1024 KHz erzielt man damit eine Auflösung von ungefähr 80 dB oder 13 Bit. Die gleiche Auflösung erzielt man mit einem Sigma-Delta-Modulator dritter Ordnung demgegenüber bereits bei halber Abtastfrequenz. Da die Leistungsaufnahme sich proportional zur Abtastfrequenz verhält, kann mit einem Modulator dritter Ordnung trotz eines weiteren Integrators Leistung eingespart werden. Dies ist vor allem im Hinblick auf batteriebetriebene Geräte von Bedeutung.

Sigma-Delta-Modulatoren dritter Ordnung mit einer einzigen Rückkopplungsschleife weisen Stabilitätsprobleme auf, weshalb man auf die Kaskadierung stabiler Modulatoren niedrigerer Ordnung übergegangen ist. Die Kaskadierung von Sigma-Delta-Modulatoren erster Ordnung hat den Vorteil, daß keine Skalierung notwendig ist, um Spannungsüberhöhungen an den Integratorausgängen zu vermeiden. Bei einer derartigen Kaskadierung wird der Quantisierungsfehler des ersten Sigma-Delta-Modulators erster Ordnung durch den nachfolgenden digital umgewandelt und dann durch ein logisches Netzwerk vom digitalen Signal des ersten subtrahiert. Das Ausgangssignal des so gebildeten Sigma-Delta-Modulators dritter Ordnung enthält einen Rauschanteil, der von dem ersten Sigma-Delta-Modulator erster Ordnung stammt und der nicht vollständig kompensiert werden kann.

In dieser Hinsicht ist eine Kaskadierung eines Sigma-Delta-Modulators zweiter Ordnung und eines nachfolgenden erster Ordnung zwar günstiger. Der Nachteil dieser Schaltung ist jedoch, daß durch die nötige Skalierung des Analogteils das Rauschen wiederum erhöht wird, da die Skalierung im Digitalteil nach dem Quantisierern wieder rückgängig gemacht werden muß.

Beispielsweise aus L.A. Williams, B.A. Wooley "Third-Order Cascaded Sigma-Delta Modulators", IEEE Transactions on Circuits and Systems, Vol. 38, No. 5, May 1991, ist eine kaskadierte Sigma-Delta Modulatorschaltung dritter Ordnung bestehend aus einem Modulator zweiter Ordnung und einem nachfolgenden Modulator erster Ordnung bekannt, die aufgrund einer geeigneten Skalierung diesen Nachteil nicht aufweist. Die bekannte Schaltung enthält einen ersten Integrator, an den die mit einem ersten Koeffizienten bewertete Differenz zwischen einem Eingangssignal und einem ersten Referenzsignal angelegt ist, und einen zweiten Integrator, an den die mit einem zweiten Koeffizienten bewertete Differenz zwischen dem Ausgangssignal des ersten Integrators und dem ersten Referenzsignal angelegt ist. Weiterhin ist ein erster Quantisierer, dem das Ausgangssignal des zweiten Integrators zugeführt wird, und ein erster Digital-Analog-Wandler, der das Ausgangssignal des ersten Quantisierers in das erste Referenzsignal umsetzt, vorgesehen. Darüber hinaus wird das mit einem dritten Koeffizienten bewertete Ausgangssignal des zweiten Integrators von dem mit einem vierten Koeffizienten bewerteten ersten Referenzsignal subtrahiert und die sich daraus ergebende Differenz anschließend mit einem fünften Koeffizienten multipliziert. Davon wird ein zweites Referenzsignal subtrahiert. Die sich daraus ergebende Differenz wird mit einem sechsten Koeffizienten bewertet und einem dritten Integrator zugeführt. Das Ausgangssignal des dritten Integrators ist an einen zweiten Quantisierer angelegt, dem wiederum ein zweiter Digial-Analog-Wandler zur Erzeugung des zweiten Referenzsignals nachgeschaltet ist. Schließlich sind den beiden Quantisierern zudem jeweils Digitalfilter nachgeschaltet, deren Ausgangssignale voneinander subtrahiert werden und das Ausgangssignal des Sigma-Delta-Modulators dritter Ordnung ergeben.

Nachteilig bei diesem Sigma-Delta-Modulator ist jedoch, daß bei dessen schaltungstechnischer Realisierung zur Kopplung des Modulators zweiter Ordnung mit dem Modulator erster Ordnung entweder ein zusätzlicher analoger Subtrahierer oder ein analoger Subtrahierer mit drei Eingängen benötigt wird.

Aus der EP-A2-0 450 947 ist eine solche Kopplung ohne zusätzlichen analogen Subtratierer oder analogen Subtratierer mit drei Eingängen bekannt.

Aufgabe der Erfindung ist es, eine alternative Realisierung für einen kaskadierten Sigma-Delta-Modulator mit einem Modulator höherer Ordnung und einem nachfolgendem Modulator erster Ordnung anzugeben, der diesen Nachteil nicht aufweist.

Die Aufgabe wird durch einen Sigma-Delta-Modulator gemäß Patentanspruch 1 gelöst. Ausgestaltungen und Weiterbildungen der Erfindung sind Gegenstand von Unteransprüchen.

Die Erfindung wird nachfolgend anhand der in den Figuren der Zeichnung dargestellten Ausführungsbeispiele näher erläutert.

Figur 1     zeigt eine allgemeine Ausführungsform eines erfindungsgemäßen Sigma-Delta-Modulators in einem Blockdiagramm und

Figur 2     zeigt dessen schaltungstechnische Realisierung in Switched-Capacitor-Technik.

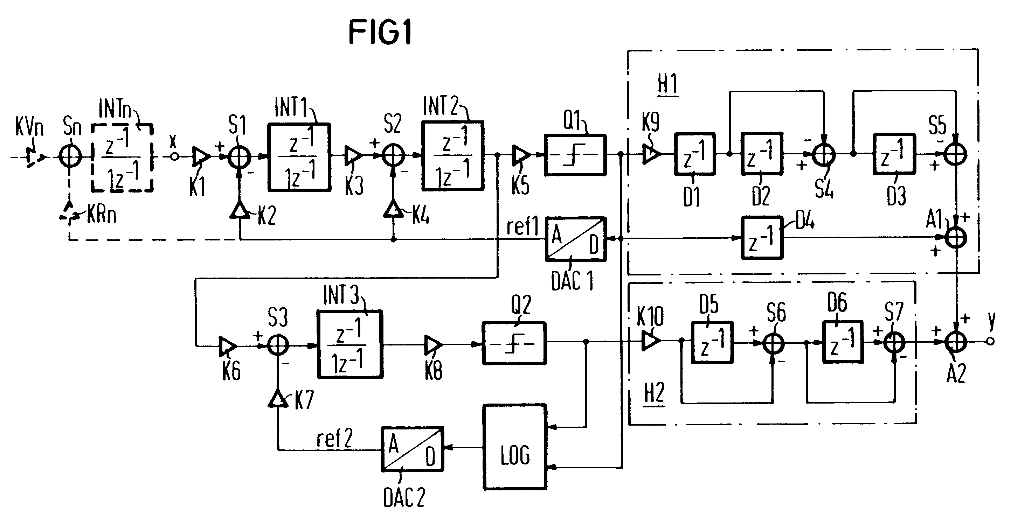

Der erfindungsgemäße Sigma-Delta-Modulator nach Figur 1 enthält einen ersten Integrator INT1, dem ein Subtrahierer S1 vorgeschaltet ist. Dem Subtrahierer S1 wird zum einen über ein Koeffizientenglied mit einem Koeffizienten K1 ein Eingangssignal x und zum anderen über ein Koeffizientenglied mit einem Koeffizienten K2 ein Referenzsignal refl zugeführt. Einem Integrierer INT2 ist ein Subtrahierer S2 vorgeschaltet, dessen einer Eingang über ein Koeffizientenglied mit einem Koeffizienten K3 an den Ausgang des Integrators INT1 angeschlossen ist und dessen anderer Eingang über ein Koeffizientenglied mit einem Koeffizienten K4 durch das Referenzsignal refl angesteuert wird. Der Ausgang des Integrators INT2 ist über ein Koeffizientenglied mit einem Koeffizienten K5 an den Eingang eines Quantisierers Q1 angeschlossen. Dem Quantisierer Q1 folgt ein Digital-Analog-Wandler DAC1, der das Ausgangssignal des Quantisierers Q1 in das Referenzsignal ref1 umsetzt.

Einem Subtrahierer S3, dessen einer Eingang über ein Koeffizientenglied mit einem Koeffizienten K6 an den Ausgang des Integrators INT2 angeschlossen ist und dessen anderer Eingang über ein Koeffizientenglied mit einem Koeffizienten K7 durch ein Referenzsignal ref2 angesteuert wird, ist ein Integrator INT3 nachgeschaltet, dem seinerseits ein Koeffizientenglied mit einem Koeffizienten K8 und ein Quantisierer Q2 folgen. Die Ausgänge der beiden Quantisierer Q1 und Q2 werden mittels einer Logik LOG additiv miteinander verknüpft. Der Logik LOG folgt ein Digital-Analog-Wandler DAC2, der aus dem von der Logik LOG abgegebenen Signal das Referenzsignal ref2 erzeugt.

Ein dem Quantisierer Q1 nachgeschaltetes Digitalfilter $\underline{H1}$ enthält ein über ein Koeffizientenglied mit einem Koeffizienten K9 an den Ausgang des Quantisierers Q1 angeschlossenes Verzögerungselement D1, ein nachfolgendes Verzögerungselement D2, einen mit den Ausgängen der Verzögerungselemente D1 und D2 verbundenen Subtrahierer S4, ein daran anschließendes Verzögerungselement D3, einen mit den Ausgängen des Subtrahierers S4 und des Verzögerungselements D3 verbundenen Subtrahierer S5, ein an den Ausgang des Quantisierers Q1 angeschlossenes Verzögerungselement D4 sowie einen mit den Ausgängen des Subtrahierers S5 und des Verzögerungselements D4 verbundenen Addierer A1. Ein Digitalfilter $\underline{H2}$ weist ein über ein Koeffizientenglied mit einem Koeffizienten K10 an den Ausgang des Quantisierers Q2 angeschlossenes Verzögerungselement D5, einen mit den Ausgängen des Verzögerungselements D5 und des Koeffizientenglieds mit den Koeffzienten K10 angeschlossenen Subtrahierer S6, ein nachfolgendes Verzögerungselement D6 sowie einen mit den Ausgängen des Subtrahierers S6 und des Verzögerungselements D6 verbundenen Subtrahierer S7 auf. Schließlich ist ein mit den Ausgängen des Addierers A1 und des Subtrahierers S7 verbundener Addierer A2 vorgesehen, an dessen Ausgang ein Ausgangssignal y anliegt.

Bei den Integrierern INT1, INT2, INT3 handelt es sich um verzögernde Integratoren, deren z-transformierte Übertragungsfunktion gleich $z^{-1}/1-z^{-1}$ ist. Zudem wird für die weiteren Betrachtungen von einem normierten Eingangssignal x sowie normierten Referenzsignalen ref1, ref2 ausgegangen. Außerdem werden die Integrierer INT1, INT2, INT3 die Quantisierer Q1, Q2 und die Digital-Analog-Wandler DAC1, DAC2 als ideal betrachtet, deren Verstärkungsfaktoren bei den jeweils vorausgehenden bzw. nachfolgenden Koeffizienten der jeweiligen Koeffizientenglieder berücksichtigt werden. Eine Anpassung an reale Verhältnisse kann damit durch entsprechende Änderungen der Koeffizienten K1 bis K10 auf einfache Weise vorgenommen werden.

Die Integratoren INT1 und INT2, der Quantisierer Q1, der Digital-Analog-Wandler DAC1 sowie die Subtrahierer S1 und S2 in Verbindung mit den entsprechenden Koeffizientengliedern bilden die erste Stufe des erfindungsgemäßen Sigma-Delta-Modulators, nämlich einen Modulator zweiter Ordnung. Diesem ist ein Modulator erster Ordnung, der die zweite Stufe bildet, nachgeschaltet. Er besteht aus dem Integrator INT3, dem Quantisierer Q2, dem Digital-Analog-Wandler DAC2 sowie dem Subtrahierer S3 in Verbindung mit den entsprechenden Koeffizientengliedern. Der zweiten Stufe wird dabei ein Fehlersignal der ersten Stufe zugeführt, das aus der Differenz des Signals vor der Quantisierung, also dem Ausgangssignal des Integrators INT2, und dem rückgewandelten quantisierten Signal, also dem Referenzsignal ref1, hervorgeht. Gegenüber dem eingangs genannten bekannten Sigma-Delta-Modulator wird diese Differenz nicht durch einen zusätzlichen Subtrahierer bzw. durch einen Subtrahierer mit drei Eingängen bei der zweiten Stufe gebildet. Dabei wird nur das Ausgangssignal des Integrators INT2 direkt der zweiten Stufe zugeführt. Das durch den Quantisierer Q1 quantisierte Signal wird also nicht mittels des Digital-Analog-Wandlers DAC1 rückgewandelt, und als Referenzsignal ref1 der zweiten Stufe zugeführt. Stattdessen werden nun die quantisierten Signale an den Ausgängen der Quantisierer Q1 und Q2 mittels der Logik LOG additiv miteinander verknüpft und anschließend durch den Digital-Analog-Wandler DAC2 umgesetzt. Das Referenzsignal ref 2 entspricht damit der rückgewandelten Summe der beiden quantisierten Signale an den Ausgängen der Quantisierer Q1 und Q2. Anstelle einer ausschließlich analogen Subtraktion tritt nun insgesamt eine teils analoge und teils digitale Subtraktion.

Den beiden Stufen sind jeweils die Digitalfilter $\underline{H1}$ bzw. $\underline{H2}$ nachgeschaltet. Das Digitalfilter $\underline{H1}$ bildet dabei die Summe aus dem mit einem Koeffizienten K9 bewerteten, dreifach verzögerten Ausgangssignal des Quantisierers Q1, aus dem mit dem doppelten negativen Koeffizienten K9 bewerteten, zweifach verzögerten Ausgangssignal des Quantisierers Q1 sowie aus dem mit den Koeffizienten K9 zuzüglich 1 bewerteten einfach verzögerten Ausgangssignal des Quantisierers Q1. Allgemein läßt sich das Digitalfilter $\underline{H1}$ also durch die z-transformierte Übertragungsfunktion funktion H1 $= z^{-1} + K9 * (1-z^{-1})^2 * z^{-1}$ beschreiben. Das Digitalfilter $\underline{H2}$ bildet bei dem vorliegenden Ausführungsbeispiel die mit einem Koeffizienten K10 bewertete Summe aus dem zweifach verzögerten Ausgangssignal des Quantisierers Q2, aus dem doppelten, negativen, einfach verzögerten Ausgangssignal des Quantisierers Q2 sowie aus dem unverzögerten Ausgangssignal des Quantisierers Q2. Die Übertragungsfunktion H2 des Digitalfilters $\underline{H2}$ ist damit gleich $K10 * (1-z^{-1})^2$.

Bevorzugt werden die Koeffizienten K1, K2, K3, K4, K6, K7, K9 und K10 so gewählt, daß der Koeffizient gleich dem Kehrwert einer Konstanten a multipliziert mit dem Verhältnis des maximalen Betragswert vx von Eingangssignal x zu Referenzsignal refl ist, wobei die Betragswerte der Referenzsignale refl und ref2 gleich groß sind. Der Koeffizient K2 ist dabei gleich dem Kehrwert der Konstanten a. Für die Koeffizienten K3 und K4 ergibt sich jeweils ein Wert, der gleich dem Verhältnis der Konstanten a zu einer Konstanten b bzw. gleich dem doppelten Kehrwert der Konstante b ist. Außerdem ist der Koeffizient K6 gleich dem Produkt aus der Konstanten b, einer Konstanten d und dem Kehrwert einer Konstanten c und der Koeffizient K7 gleich dem doppelten Kehrwert der Konstanten c. Schließlich ist der Koeffizient K9 gleich dem Kehrwert der Konstanten d minus 1 und der Koeffizient K10 gleich dem Kehrwert der Konstanten d. Die Konstanten a, b, c entsprechen dabei beispielsweise den Dämpfungsfaktoren der Integratoren INT1, INT2, INT3 und die Konstante d bildet einen wählbaren Stabilisierungsfaktor. Formal dargestellt bedeutet dies also:

$$K1 = vref/(a \times vx)$$
$$K2 = 1/a$$
$$K3 = a/b$$
$$K4 = 2/b$$
$$K6 = (b \times d)/c$$
$$K7 = 2/c$$
$$K9 = (1/d)-1$$
$$K10 = 1/d$$

Außerdem ergibt sich für die Koeffizienten K5 und K8

$$K5 = b$$
$$K8 = c,$$

wobei es sich dabei nur um rein rechnerische Größen handelt, die in den Komparatoren enthalten sind.

Beispielhaft sei angenommen, daß der Digital-Analog-Wandler DAC1 die Werte +1V, -1V und der Digital-Analog-Wandler DAC2 die Werte +1V, 0, -1V erzeugt. Das Eingangssignal x nimmt dabei Werte zwischen -2V und +2V an. Das bedeutet, daß der maximale Betragswert des Eingangssignals x gleich 2 und der der Referenzsignale ref1, ref2 gleich 1 ist, also vx = 2, vref1 = 1 und vref2 = 1. Daraus ergibt sich nun, daß der Koeffizient K1 = 0,25, die Koeffizienten K2, K3, K4 = 0,5, die Koeffizienten K6, K7, K9 = 1, die Koeffizienten K8, K10 = 2 und der Koeffizient K5 = 4 werden.

Für die z-Transformierte Y(z) des Ausgangssignals y ergibt sich damit in Abhängigkeit von der z-Transformierten X(z) des Eingangssignals x und der z-Transformierten $N_2(z)$ des Quantisierungsrauschens des Quantisierers Q2:

$$Y(z) = z^{-3} * x(z) + (1-z^{-1})^3 * N_2(z).$$

Durch Umstellen dieser Gleichung bzw. durch Anpassen der Koeffizienten K1 bis K10 an die jeweils gegebenen Bedingungen können unterschiedliche Ausführungsformen erzielt werden. Darüber hinaus ist es möglich, durch Vorschalten weiterer Integrierer INTn in Verbindung mit entsprechenden Subtrahierern Sn und Koeffizientengliedern KVn, KRn, die Ordnung der ersten Stufe zu erhöhen.

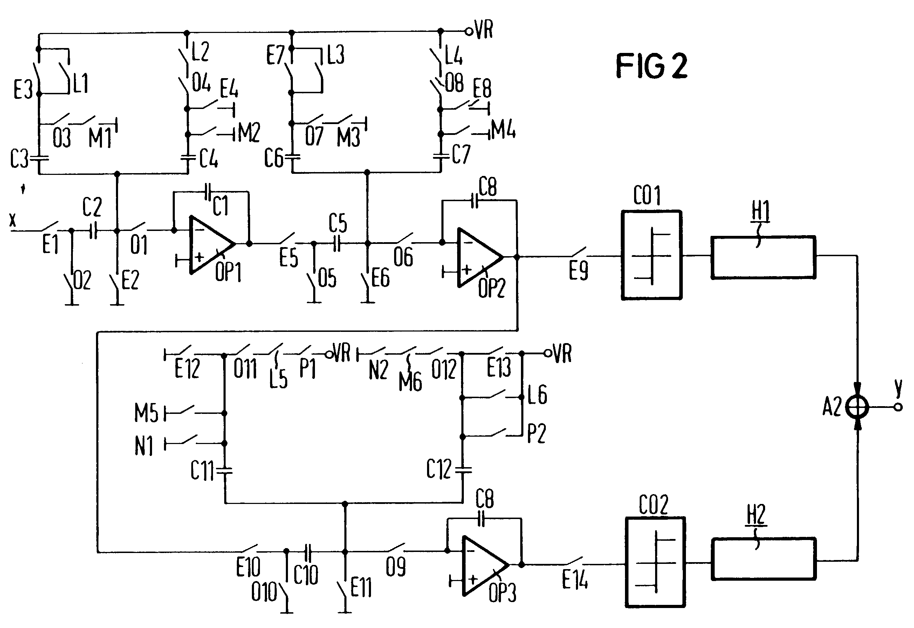

Bei der in Figur 2 der Zeichnung dargestellten, in Switched-Capacitor-Technik ausgeführten Realisierung eines erfindungsgemäßen Sigma-Delta-Modulators ist ein Operationsverstärker OP1 vorgesehen, der zwischen Ausgang und invertierendem Eingang über eine Kapazität C1 rückgekoppelt ist und dessen nichtinvertierender Eingang an einem Bezugspotential liegt. Der invertierende Eingang des Operationsverstärkers OP1 ist zudem über einen Schalter O1 auf einen Anschluß einer Kapazität C2 aufschaltbar. Auf den anderen Anschluß der Kapazität C2 ist zum einen über einen Schalter E1 das Eingangssignal x und zum anderen über einen Schalter O2 das Bezugspotential aufschaltbar. Zwischen Bezugspotential und dem einen Anschluß der Kapazität C2, der zudem mit jeweils einem Anschluß zweier Kapazitäten C3 und C4 verbunden ist, liegt ein Schalter E2. Der andere Anschluß der Kapazität C3 ist zum einen über einen Schalter E3 sowie einen parallel dazu liegenden Schalter L1 mit einem Referenzpotential VR und zum anderen über einen Schalter O3 und einen in Reihe dazu liegenden Schalter M1 mit dem Bezugspotential koppelbar. Der andere Anschluß der Kapazität C4 ist über eine Reihenschaltung eines Schalters L2 und eines Schalters O4 mit dem Referenzpotential VR und über eine Parallelschaltung eines Schalters E4 und eines Schalters M2 auf das Bezugspotential aufschaltbar.

Zwischen dem Ausgang des Operationsverstärkers OP1 und einem Anschluß einer Kapazität C5 liegt ein Schalter E5. Zwischen den einen Anschluß der Kapazität C5 und Bezugspotential ist zudem ein Schalter O5 gelegt. Der andere Anschluß der Kapazität C5 ist zum einen mit jeweils einem Anschluß einer Kapazität C6 und C7 verbunden und zum anderen über einen Schalter O6 mit dem nichtinvertierenden Eingang eines Operationsverstärkers OP2 sowie über einen Schalter E6 mit dem Bezugspotential koppelbar. Der Operationsverstärker OP2, dessen nichtinvertierender Eingang am Bezugspotential liegt, ist über eine Kapazität C8 zwischen Ausgang und invertierendem Eingang rückgekoppelt. Der andere Anschluß der Kapazität C6 ist zum einen über zwei parallel liegende Schalter E7 und L3 mit dem Referenzpotential VR und zum anderen über zwei in Reihe liegende Schalter O7 und M3 mit dem Bezugspotential koppelbar. Der andere Anschluß der Kapazität C7 ist über eine Reihenschaltung eines Schalters O8 und eines Schalters L4 auf das Referenzpotential VR und über die Parallelschaltung eines Schalters E8 und eines Schalters M4 auf das Bezugspotential aufschaltbar.

Schließlich ist der Ausgang des Operationsverstärkers OP2 über einen Schalter E9 mit dem Eingang eines Komparators CO1 koppelbar, der den Quantisierer Q1 entsprechend Figur 1 bildet. Diesem wiederum ist das digitale Filter H1 nachgeschaltet.

Die nachfolgende zweite Stufe enthält einen Operationsverstärker OP3, dessen nichtinvertierender Eingang an dem Bezugspotential liegt und der zwischen Ausgang und nichtinvertierenden Eingang über eine Kapazität C9 rückgekoppelt ist. Der nichtinvertierende Eingang des Operationsverstärkers OP3 ist zudem über einen Schalter O9 mit einem Anschluß einer Kapazität C10 koppelbar, deren anderer Anschluß zum einen über einen Schalter E10 auf den Ausgang des Operationsverstärkers OP2 und zum anderen über einen Schalter O10 auf das Bezugspotential aufschaltbar ist. Der eine Anschluß der Kapazität C10 ist weiterhin zum einen über einen Schalter E11 mit dem Bezugspotential koppelbar und zum anderen mit jeweils einem Anschluß zweier Kapazitäten C11 und C12 verbunden. Der andere Anschluß der Kapazität C11 ist zum einen über eine Parallelschaltung eines Schalters E12, eines Schalters M5 und eines Schalters N1 auf das Bezugspotential und zum anderen über eine Reihenschaltung eines Schalters O11, eines Schalters L5 und eines Schalters P1 auf das Referenzpotential VR aufschaltbar. Der andere Anschluß der Kapazität C12 ist über eine Reihenschaltung eines Schalters O12, eines Schalters M6 und eines Schalters N2 mit dem Bezugspotential und über eine Parallelschaltung eines Schalters E13, eines Schalters L6 und eines Schalters P2 mit dem Referenzpotential VR koppelbar.

Zwischen den Eingang eines Komparators CO2, der den Quantisierer Q2 nach Figur 1 bildet und dem das Filter H2 nachgeschaltet ist, und den Ausgang des Operationsverstärkers OP3 ist ein Schalter E14 gesetzt. Die Ausgänge der beiden Digitalfilter H1 und H2 sind, wie bereits bei Figur 1 beschrieben, auf den Addierer A2 geführt.

Bei sämtlichen Schaltern handelt es sich um steuerbare Schalter, wobei die Schalter E1 bis E14 durch eine Phase eines Taktsignals und die Schalter O1 bis O12 durch die andere Phase dieses Taktsignals gesteuert werden. Außerdem werden die Schalter L1 bis L6 durch das Ausgangssignal des Komparators CO1 und die Schalter M1 bis M6 durch dessen invertiertes Ausgangssignal gesteuert. Schließlich werden die Schalter P1 und P2 sowie die Schalter N1 und N2 durch das Ausgangssignal bzw. das invertierte Ausgangssignal des Komparators CO2 betrieben. Geht man von einem normierten Wert für die Kapazitäten C1, C8 und C9 aus, der gleich eins sei, so ergibt sich für die Kapazität C2 der Wert K1, für die Kapazitäten C3 und C4 der Wert K2, für die Kapazität C5 der Wert K3 und für die Kapazitäten C6 und C7 der Wert K4. Für die Kapazität C10 ist demnach ein Wert K6 und für die Kapazitäten C11 und C12 der Wert K7 vorgesehen. Die Werte der Koeffizienten K5 und K8 aus Figur 1 repräsentieren dabei rechnerische Werte, die durch die beiden Komparatoren CO1 und CO2 gegeben sind. Darüber hinaus ist die Referenzspannung VR so gewählt, daß sie gleich dem Maximalwert des Eingangssignals x ist.

Der Sigma-Delta-Modulator nach Figur 2 ist derart ausgelegt, daß der Digital-Analog-Wandler der zweiten Stufe neben dem bereits beim Digital-Analog-Wandler der ersten Stufe auftretenden Referenzsignal, welches nur zwei Werte, nämlich den positiven und den negativen Wert der Referenzspannung VR, annimmt, nur noch den Wert Null zu erzeugen hat. Bei dem vorliegenden Sigma-Delta-Modulator in Switches-Capacitor-Technik werden die beiden Digital-Analog-Wandler durch eine einzige Referenzspannungsquelle, die die Referenzspannung VR erzeugt, und durch die jeweils zugeordneten Schalter realisiert. Für den Digital-Analog-Wandler der ersten Stufe sind dies die Schalter L1 bis L4 und M1 bis M4. Beim Digital-Analog-Wandler der zweiten Stufe sind dazu die Schalter P1 und P2 sowie N1 und N2 vorgesehen. Die logische Verknüpfung der Ausgangssignale der beiden Quantisierer, d. h. der beiden Komparatoren CO1 und CO2, erfolgt ebenfalls durch Schalter, die zusätzlich beim Digital-Analog-Wandler der zweiten Stufe eingesetzt werden. Es sind dies die Schalter L5, L6, M5 und M6.

Schließlich sind die Koeffizienten K1, K2, K3 und K4 = 0,5, die Koeffizienten K6, K7 und K9 = 1, die Koeffizienten K8 und K10 = 2 sowie der Koeffizient K5 = 4 gewählt. Damit ergibt sich für die Kapazitäten C2 bis C7 der halbe Wert und für die Kapazitäten C10 bis C12 der doppelte Wert der Kapazitäten C1, C8, C9.

**Patentansprüche**

1.  Sigma-Digital-Modulator

    mit einem ersten Integrator (INT1) an den die Differenz zwischen einem mit einem ersten Koeffizienten (K1) bewerteten Eingangssignal (x) und einem mit einem zweiten Koeffizienten (K2) bewerteten ersten Referenzsignal (ref1) angelegt ist, mit einem zweiten Integrator (INT2), an den die Differenz zwischen dem mit einem dritten Koeffizienten (K3) bewerteten Ausgangssignal des ersten Integrators (INT1) und dem mit einem vierten Koeffizienten (K4) bewerteten ersten Referenzsignal (ref1) angelegt ist,

mit einem ersten Quantisierer (Q1), an den das mit einem fünften Koeffizienten (K5) bewertete Ausgangssignal des zweiten Integrators (INT2) angelegt ist,

mit einem ersten Digital-Analog-Wandler (DAC1), der das Ausgangssignal des ersten Quantisierers (Q1) in das erste Referenzsignal (ref1) umsetzt,

mit einem dritten Integrator (INT3), an den die Differenz zwischen dem mit einem sechsten Koeffizienten (K6) bewerteten Ausgangssignal des zweiten Integrators (INT2) und einem mit einem siebten Koeffizienten (K7) bewerteten zweiten Referenzsignal (ref2) angelegt ist,

mit einem zweiten Quantisierer (Q2), an den das mit einem achten Koeffizienten (K8) bewertete Ausgangssignal des dritten Integrators (INT3) angelegt ist, gekennzeichnet durch

eine Logikschaltung (LOG), die die Ausgangssignale von erstem und zweitem Quantisierer (Q1, Q2) miteinander addiert,

einen zweiten Digital-Analog-Wandler (DAC2), der das Ausgangssignal der Logikschaltung (LOG) in das zweite Referenzsignal (ref2) umsetzt, sowie

einen dem ersten Quantisierer (Q1) nachgeschalteten ersten Digitalfilter (H1) und einen dem zweiten Quantisierer (Q2) nachgeschalteten zweiten Digitalfilter (H2), deren Ausgangssignale miteinander addiert werden.

2. Sigma-Delta-Modulator nach Anspruch 1,
   **dadurch gekennzeichnet,**
   daß das erste Digitalfilter (H1) die Summe aus dem mit einem neunten Koeffizienten (K9) bewerteten, dreifach verzögerten Ausgangssignal des ersten Quantisierers (Q1), aus dem mit dem doppelten, negativen neuen Koeffizienten (K9) bewerteten, zwei fach verzögerten Ausgangssignal des ersten Quantisierers (Q1) sowie aus dem mit dem neunten Koeffizienten (K9) plus eins bewerteten einfach verzögerten Ausgangssignal des ersten Quantisierers (C1) bildet und daß das zweite Digitalfilter (H2) die mit einem zehnten Koeffizienten (K10) bewertete Summe aus dem zweifach verzögerten Ausgangssignal des zweiten Quantisierers (Q2), aus dem doppelten, negativen, einfach verzögerten Ausgangssignal des zweiten Quantisierers (Q2) sowie aus dem unverzögerten Ausgangssignal des zweiten Quantisierers (Q2) bildet.

3. Sigma-Delta-Modulator nach Anspruch 2,

   **dadurch gekennzeichnet,** daß der erste Koeffizient (K1) gleich dem Kehrwert einer ersten Konstanten multipliziert mit dem Verhältnis der maximalen Betragswerte von Eingangssignal (x) zu erstem Referenzsignal (ref1) ist,

daß der zweite Koeffizient (K2) gleich dem Kehrwert der ersten Konstanten ist,

daß der dritte Koeffizient (K3) gleich dem Verhältnis der ersten Konstanten zu einer zweiten Konstanten ist,

daß der vierte Koeffizient (K4) gleich dem doppelten Kehrwert der zweiten Konstanten ist,

daß der sechste Koeffizient (K6) gleich dem Produkt aus der zweiten Konstante, einer vierten Konstante und dem Kehrwert einer dritten Konstante ist,

daß der siebte Koeffizient gleich dem doppelten Kehrwert der dritten Konstante ist,

daß der neunte Koeffizient gleich dem Kehrwert der vierten Konstanten minus eins ist,

daß der zehnte Koeffizient gleich dem Kehrwert der vierten Konstanten ist und

daß die maximalen Betragswerte der beiden Referenzsignae (ref1, ref2) gleich groß sind.

4. Sigma-Delta-Modulator nach einem der Ansprüche 1 bis 3,
   **dadurch gekennzeichnet,**
   daß dem ersten Integrator (INT1) mindestens ein weiterer Integrator (INTZ) vorgeschaltet ist, dem jeweils die Differenz des jeweils mit weiteren Koeffizienten (KV, KR) bewerteten Eingangssignal und des ersten Referenzsignals (ref 1) zugeführt wird.

### Claims

1. Sigma-delta modulator having a first integrator (INT1) to which the difference between an input signal (x), evaluated with a first coefficient (K1), and a first reference signal (ref1), evaluated with a second coefficient (K2), is applied, having a second integrator (INT2) to which the difference between the output signal, evaluated with a third coefficient (K3), of the first integrator (INT1) and the first reference signal (ref1), evaluated with a fourth coefficient (K4), is applied, having a first quantizer (Q1) to which the output signal, evaluated with a fifth coefficient (K5), of the second integrator (INT2) is applied, having a first digital-to-analogue converter (DAC1) which converts the output signal of the first quantizer (Q1) into the first reference signal (ref1), having a third integrator (INT3) to which the difference between the output signal, evaluated with a sixth coefficient (K6), of the second integrator (INT2) and a second reference signal (ref2), evaluated with a seventh coefficient (K7), is applied, having a second quantizer (Q2) to which the output signal, evaluated with an eighth coefficient (K8), of the third integrator (INT3) is applied, characterized by a logic circuit (LOG) which adds the output signals of first and second quantizer (Q1, Q2) to one another, a second digital-to-analogue converter (DAC2) which converts the output signal of the logic circuit (LOG) into the second reference signal (ref2), as well as a first digital filter (H1), connected downstream of the first quantizer (Q1), and a second digital filter (H2), connected downstream of the second quantizer (Q2), the output signals of which filters are added to one another.

2. Sigma-delta modulator according to Claim 1, characterized in that the first digital filter (H1) forms the sum of the triply delayed output signal, evaluated with a ninth coefficient (K9), of the first quantizer (Q1), of the doubly delayed output signal, evaluated with the double, negative ninth coefficient (K9), of the first quantizer (Q1) as well as of the singly delayed output signal, evaluated with the ninth coefficient (K9) plus one, of the first quantizer (Q1), and in that the second digital filter (H2) forms the sum, evaluated with a tenth coefficient (K10), of the doubly delayed output signal of the second quantizer (Q2), of the double, negative, singly delayed output signal of the second quantizer (Q2) as well as of the undelayed output signal of the second quantizer (Q2).

3. Sigma-delta modulator according to Claim 2, characterized in that the first coefficient (K1) is equal to the reciprocal value of a first constant multiplied by the ratio of the maximum amount values of input signal (x) to first reference signal (ref1), in that the second coefficient (K2) is equal to the reciprocal value of the first constant, in that the third coefficient (K3) is equal to the ratio of the first constant to a second constant, in that the fourth coefficient (K4) is equal to twice the reciprocal value of the second constant, in that the sixth coefficient (K6) is equal to the product of the second constant, a fourth constant and the reciprocal value of a third constant, in that the seventh coefficient is equal to twice the reciprocal value of the third constant, in that the ninth coefficient is equal to the reciprocal value of the fourth constant minus one, in that the tenth coefficient is equal to the reciprocal value of the fourth constant and in that the maximum amount values of the two reference signals (ref1, ref2) are of identical size.

4. Sigma-delta modulator according to one of Claims 1 to 3, characterized in that there is connected upstream of the first integrator (INT1) at least one further integrator (INTZ) to which in each case the difference of the input signal, in each case evaluated with further coefficients (KV, KR), and of the first reference signal (ref 1) is supplied.

**Revendications**

1. Modulateur sigma-delta comportant

   un premier intégrateur (INT1), auquel est appliquée la différence entre un premier signal (x) d'entrée pondéré par un premier coefficient (K1) et un premier signal (ref1) de référence pondéré par un second coefficient (K2),
   un second intégrateur (INT2), auquel est appliquée la différence entre le signal de sortie, pondéré par un troisième coefficient (K3), du premier intégrateur (INT1) et le premier signal (ref1) de référence pondéré par un quatrième coefficient (K4),
   un premier quantificateur (Q1), auquel est appliqué le signal de sortie, pondéré par un cinquième coefficient (K5), du second intégrateur (INT2),
   un premier convertisseur (DAC1) numérique-analogique, qui convertit le signal de sortie du premier quantificateur (Q1) en le premier signal (ref1) de référence,
   un troisième intégrateur (INT3), auquel est appliquée la différence entre le signal de sortie, pondéré par un sixième coefficient (K6), du second intégrateur (INT2) et un second signal (ref2) de référence pondéré par un septième coefficient (K7),
   un second quantificateur (Q2) auquel est appliqué le signal de sortie, pondéré par un huitième coefficient (K8), du troisième intégrateur (INT3), caractérisé par un circuit logique (LOG), qui additionne l'un à l'autre les signaux de sortie des premier et second quantificateurs (Q1, Q2),
   un second convertisseur (DAC2) numérique-analogique, qui convertit le signal de sortie du circuit logique (LOG) en le second signal (ref2) de référence, ainsi que
   un premier filtre (H1) numérique branché en aval du premier quantificateur (Q1) et un second filtre (H2) numérique branché en aval du second quantificateur (Q2), les signaux de sortie de ces premier et second filtres numériques étant additionnés l'un à l'autre.

2. Modulateur sigma-delta suivant la revendication 1, caractérisé en ce que
   le premier filtre (H1) numérique forme la somme du signal de sortie, pondéré par un neuvième coefficient (Q9) et retardé trois fois, du premier quantificateur (Q1), du signal de sortie, qui est pondéré par le nouveau coefficient (K9) négatif doublé et qui est retardé deux fois, du premier quantificateur (Q1) ainsi que du signal de sortie, pondéré par le neuvième coefficient (K9) plus un et retardé une fois, du premier quantificateur (Q1) et le second filtre numérique (H2) forme la somme, pondérée par un dixième coefficient (K10), du signal de sortie retardé deux fois du second quantificateur (Q2), du signal de sortie, doublé négatif retardé une fois, du second quantificateur (Q2) ainsi que du signal de sortie non retardé du second quantificateur (Q2).

3. Modulateur sigma-delta suivant la revendication 2,

   caractérisé en ce que
   le premier coefficient (K1) est égal à l'inverse d'une première constante multipliée par le rapport du module maximum du signal (x) d'entrée à celui du premier signal (ref1) de référence,
   le second coefficient (K2) est égal à l'inverse de la première constante,
   le troisième coefficient (K3) est égal au rapport de la première constante à une seconde constante,
   le quatrième coefficient (K4) est égal au double de l'inverse de la seconde constante,
   le sixième coefficient (K6) est égal au produit de la seconde constante, d'une quatrième constante et de l'inverse d'une troisième constante,
   le septième coefficient est égal au double de l'inverse de la troisième constante,
   le neuvième coefficient est égal à l'inverse de la quatrième constante, moins un,
   le dixième coefficient est égal à l'inverse de la quatrième constante et
   les modules maxima des deux signaux (ref1, ref2) de référence sont égaux.

4. Modulateur sigma-delta suivant l'une des revendications 1 à 3, caractérisé en qu'au moins un autre intégrateur (INTZ), auquel est envoyée la différence entre le signal d'entrée pondéré par d'autres coefficients (KV, KR) et le premier signal (ref1) de référence, est branché en amont du premier intégrateur (INT1).

# FIG1

EP 0 559 944 B1

FIG 2

EP 0 559 944 B1